(19) Europäisches Patentamt
European Patent Office
Office européen des brevets

(11) **EP 4 199 349 A1**

(12) **EUROPEAN PATENT APPLICATION**

(43) Date of publication:
**21.06.2023 Bulletin 2023/25**

(21) Application number: **21214320.0**

(22) Date of filing: **14.12.2021**

(51) International Patent Classification (IPC):
**H03B 17/00** (2006.01)  **G02F 1/00** (2006.01)
**G01J 3/45** (2006.01)  **G01J 3/28** (2006.01)
**G01N 21/39** (2006.01)

(52) Cooperative Patent Classification (CPC):
**H03B 17/00; G01J 3/28; G01J 3/45;** G02F 1/03;
G02F 2203/50

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Airbus Defence and Space GmbH
82024 Taufkirchen (DE)**

(72) Inventor: **KOLLER, Silvio B.
82024 Taufkirchen (DE)**

(74) Representative: **LKGLOBAL
Lorenz & Kopf Patentanwalt
Attorney at Law PartG mbB
Brienner Straße 11
80333 München (DE)**

Remarks:
Amended claims in accordance with Rule 137(2)
EPC.

(54) **RF SIGNAL GENERATION USING BIREFRINGENT ELEMENTS IN AN OPTICAL RESONATOR**

(57) Devices and methods for generating a radio frequency signal using a first laser beam and a second laser beam are described. A first laser beam (22A) having a first polarization and a first frequency, and a second laser beam (22B) having a second polarization different to the first polarization and a second frequency different to the first frequency are emitted towards an optical resonator with a cavity (102), a first mirror (110), a second mirror (112), and a birefringent element (109). The first mirror (110) and the second mirror (112) are arranged opposite to each other with at least a part of the cavity (102) in between. The birefringent element (10) defines a first optical length (117) for the first laser beam (22A) and a second optical length (119) for the second laser beam (22B). The first laser beam (22A) and the second laser beam (22B) are locked to the optical resonator (100). A resulting signal is obtained by interference of the first laser beam (22A) and the second laser beam (22B). A beat detector arrangement (50, 60) determines a beat frequency of the resulting signal which corresponds to the radio frequency signal

Fig. 8

EP 4 199 349 A1

**Description**

Technical Field

The description relates to generating low noise and short-term stable radio frequency signals. In particular, the description relates to an optical resonator arrangement and a method for generating a radio frequency signal from optical signals.

Technical Background

Radio frequency signals are used in several applications, particularly for transmitting signals between a transmitter and a receiver. For example, radio frequency signals are used in space and satellite applications for transmitting information between satellites that are in orbit and/or between a satellite and a ground station or a device on the surface of the earth.

Stable and low-noise radio frequency signals may be generated by using a so-called frequency comb. However, such a frequency comb is a complex and expensive device.

Summary

It may be seen as an object to reduce complexity for generating a low-noise and stable radio frequency signal. This object is solved by the subject matter of the independent claims.

An optical resonator arrangement and a method according to the features of the independent claims is provided. Further developments can be derived from the dependent claims and from the following description.

Many of the features described with reference to the optical resonator arrangement may be implemented as method steps, or vice versa. Therefore, the description provided in the context of the optical resonator arrangement applies in an analogous manner also to the method. In particular, the described functions of the optical resonator arrangement may be implemented as method steps, and vice versa.

According to an aspect, an optical resonator arrangement for generating a radio frequency signal is provided. The optical resonator arrangement comprises a laser beam feeder, an optical resonator, and a beat detector arrangement. The laser beam feeder is configured to emit a first laser beam having a first polarization and a first frequency and a second laser beam having a second polarization different to the first polarization and a second frequency different to the first frequency. The optical resonator is arranged to receive the first laser beam and the second laser beam. The beat detector arrangement is arranged to receive the first laser beam and the second laser beam and is configured to determine a beat frequency between the first laser beam and the second laser beam. The optical resonator arrangement is configured to lock the first laser beam and the second laser beam to the optical resonator. The optical resonator comprises a housing with a cavity, a first mirror, a second mirror, and at least one birefringent element. The first mirror and the second mirror are arranged at a predetermined physical distance from each other along a path of the first laser beam and the second laser beam. The at least one birefringent element is arranged in the cavity and defines a first optical length for the first laser beam and a second optical length for the second laser beam.

The birefringent element may particularly be a component that comprises a material with birefringent characteristics. For example, the birefringent element is a plate or disc that is arranged in the optical paths of the laser beams, particularly within the cavity of the optical resonator. Alternatively or additionally, the birefringent element is part of one or both mirrors of the optical resonator, as described in greater detail below.

While the optical resonator is described with a first and a second mirror, it should be understood that the optical paths through the optical resonator may be defined by three or more mirrors without departing from the scope of the description.

The optical resonator arrangement generates a stable and low-noise (in regards of phase and frequency) radio frequency signal based on optical signals with a frequency-stable optical signal. The first laser beam and the second laser beam are optical signal with different polarization. These beams are used as a basis for generating the radio frequency signal. Due to the different polarization, the paths of the differently polarized laser beams through the birefringent element have different lengths. For example, when the birefringent element is part of the first and/or second mirror, the differently polarized laser beams are reflected by the first and second mirror at different positions, i.e., the optical length of the optical resonator is different for the first and second laser beam. The same optical resonator has two different longitudinal modes depending on the polarization of the laser beams. Therefore, when the first and second laser are locked to the optical resonator, the first and second laser have different frequencies, because of the different optical lengths for the differently polarized laser beams. Then, the first and second laser beams with the first and second frequency, respectively, are received by a beat detector arrangement that determined the beat frequency between the first and second laser beam. The beat frequency results from the interference between the first and second laser beam.

The beat frequency corresponds to the radio frequency signal.

Laser signals have a highly stable frequency. The beat frequency between two laser signals with different frequency is also highly stable. However, the beat frequency differs from the laser signal frequency by orders of magnitude. Therefore, laser signals with very high frequencies in the optical domain are converted directly in the radio frequency domain.

For example, the optical resonator arrangement receives laser signals with a frequency in the optical range between about 100 THz and about 100 THz. When two optical signals with different frequencies interfere, the beat frequency thereof is by orders of magnitude smaller than the optical range. For example, the beat frequency may be in the very high frequency range (30 to 300 MHz) or even in the Ultra high frequency range (300 MHz to 3 GHz). Preferably, the optical resonator and the first and second mirrors are designed so that the modes for the different laser signals generate a beat frequency of 10 MHz to 200MHz or several hundreds of MHz.

According to an embodiment, the at least one birefringent element is located between the first mirror and the second mirror. Alternatively or additionally, at least one birefringent element is a part of one or both of the first mirror and the second mirror.

To implement two optical paths with different optical lengths in the optical resonator, the birefringent element can be placed at different positions.

In one example, the birefringent element is arranged within the cavity between the first and second mirror. In this example, the birefringent element is spaced apart from the first mirror and the second mirror. The differently polarized laser beams pass through the birefringent element along different paths. Therefore, the cavity has two different optical lengths for differently polarized laser beams.

In another example, the birefringent element is part of one or both the first mirror and the second mirror. For example, the birefringent element is implemented by the first mirror and/or the second mirror being made of or comprising a crystalline structure with birefringent characteristics. Alternatively, the first mirror and/or the second mirror include a surface with birefringent characteristics, e.g., a coating with one or more layers of birefringent material.

In another example, a birefringent element is located between the first mirror and the second mirror and spaced apart from each one of these mirrors while one or both of the first mirror and the second mirror have birefringent characteristics and are designed as described in the foregoing example.

These examples all have the same or similar effect, namely that the cavity has two different optical lengths for differently polarized laser beams.

According to another embodiment, the first polarization is orthogonal to the second polarization.

For example, the laser beam feeder is configured to emit the first laser beam having a vertical polarization and the second laser beam having a horizontal polarization. The first laser beam and the second laser beam may pass a 45° polarizer when they are emitted by the laser beam feeder.

According to an embodiment, each of the first mirror and the second mirror includes multiple layers of birefringent material.

For example, the first mirror and/or the second mirror may include calcite ($Ca[CO_3]$). In particular, the calcite may be arranged in different and multiple layers thereby forming a reflection surface of the first and second mirror. In another example, the first and/or second mirror themselves may have a crystalline structure such that they are birefringent.

Differently polarized laser beams are reflected by a birefringent material at different depths relating to its outer surface. Thus, the optical resonator has two different optical lengths for the two differently polarized laser beams.

According to an embodiment, the first mirror is arranged at an inlet opening of the optical resonator and the second mirror is arranged at an outlet opening of the optical resonator. The cavity extends between the inlet opening and the outlet opening.

The first and second mirror may be attached or mounted to the housing of the optical resonator by a fixation element. The first and second laser beam are locked to the same optical resonator which nevertheless has two different optical lengths for the differently polarized laser beams. Due to these different optical lengths of the optical resonator to which two laser beams with different frequencies are locked, a stable and low noise beat frequency can be generated.

According to an embodiment, the first mirror and the second mirror are fixedly attached to the housing of the optical resonator.

In other words, the first mirror and the second mirror are located at a predetermined physical distance. This physical distance is substantially constant and unvarying at least for a certain period of time.

According to an embodiment, the beat detector arrangement includes a first beat detector that is arranged to receive the first laser beam and the second laser beam at the outlet opening of the optical resonator.

The first beat detector arrangement may include photodiodes that detect the first and second laser beam and determine the beat frequency between these two laser beams. The first beat detector provides the beat frequency for use by other applications, for example for communication purposes or for any other radio frequency applications. The beat frequency may be referred to as RF signal. The RF signal may be processed by RF signal components. For example, the RF signal may be varied in frequency to achieve a frequency desired for a certain application or use case.

According to an embodiment, the optical resonator arrangement comprises a lambda/2 waveplate that is arranged in a laser path of the first laser beam and the second laser beam between the optical resonator and the first beat detector. The lambda/2 waveplate is configured to modify the polarization of the first laser beam and/or the second laser beam so that the first laser beam and the second laser beam have the same polarization and interfere with each other to create a resulting signal.

According to an embodiment, the first beat detector includes a polarizing beam splitter, a first detector photodiode, and a second detector photodiode, wherein the polarizing beam splitter is configured to stabilize an intensity and to distribute an energy of the first laser beam and the second laser beam to the first detector photodiode and the second detector photodiode.

The first and second detector photodiodes detect the resulting signal (interference of the first laser beam and the second laser beam) and thereby enable determining the beat frequency.

According to an embodiment, the first detector photodiode and the second detector photodiode are configured to determine the beat frequency of the resulting signal.

According to an embodiment, the beat detector arrangement includes a second beat detector that is arranged to receive the first laser beam and the second laser beam at the inlet opening of the optical resonator.

The second beat detector is functionally and/or structurally similar or identical to the first beat detector. In other words, once the first and second laser beams have been locked to the optical resonator, the beat frequency can be determined based on the first and second laser beams before these enter the optical resonator or after the first and second laser beams have left the optical resonator at the outlet opening.

According to an embodiment, the optical resonator arrangement further comprises a reference device and a test device. The reference device is configured to emit a reference optical signal with a reference frequency towards the laser beam feeder with the reference optical signal being the basis for emitting the first laser beam and the second laser beam. The test device is configured to emit a test optical signal at an unknown test optical signal frequency. The beat detector arrangement includes a second beat detector that is arranged to receive the reference optical signal and the test optical signal, and that is configured to determine a beat frequency of the reference optical signal interfering with the test optical signal. The optical resonator arrangement is configured to determine the test optical signal frequency of the test optical signal based on the beat frequency at the second beat detector and the reference frequency.

This embodiment enables determining a frequency of an optical signal emitted by a device under test (test device). First, the reference optical signal is locked to the optical resonator as described above. The reference optical signal and the test optical signal are fed to the second beat detector which detects the beat frequency between the reference optical signal and the test optical signal. With the known reference frequency of the reference optical signal and the determined beat frequency, the test optical signal frequency can be determined.

According to an embodiment, the optical resonator arrangement is configured to vary the reference frequency and to lock the reference optical signal to the optical resonator at different modes of the optical resonator.

The frequency distance between different modes of the optical resonator is known. When the reference frequency is varied to correspond to another mode of the optical resonator, the varied frequency of the reference optical signal is also known. With the varied reference frequency, the reference frequency may be closer to the test optical signal frequency and determining the beat frequency therebetween may be facilitated. This process may be iteratively repeated until the reference frequency is close enough to the test optical signal frequency in order to clearly determine a beat frequency therebetween that is used to determine the test optical signal frequency based on the known reference frequency and the detected beat frequency.

According to an embodiment, the optical resonator arrangement is configured to determine a mode of the optical resonator belonging to the varied reference frequency and to determine a value of the varied reference frequency based on the determined mode of the optical resonator.

The reference frequency of the reference optical signal can be varied in a free manner. However, to determine the value of the reference frequency, the beat detector arrangement is used. A beat frequency between the first laser beam and the second laser beam is determined. This beat frequency is used to count the number of modes that are traversed by the reference frequency when it is varied. In other words, the initial frequency of the reference optical signal is known, and the variation of the reference frequency is determined based on the variations of the beat node between the first and second laser beam. When doing so, the actual frequency of the reference optical signal is known. With this known frequency of the reference optical signal and the beat frequency detected at the second beat detector (the beat frequency between the reference optical signal and the test optical signal), the frequency of the test optical signal is determined.

According to a further aspect, a method for generating a radio frequency signal using a first laser beam and a second laser beam is provided. The method comprises the steps: emitting a first laser beam having a first polarization and a first frequency and a second laser beam having a second polarization different to the first polarization and a second frequency different to the first frequency towards an optical resonator with a cavity, a first mirror, a second mirror, and at least one birefringent element, wherein the first mirror and the second mirror are arranged opposite to each other with at least a part of the cavity in between, and wherein the at least one birefringent element is arranged in the cavity and defines a first optical length for the first laser beam and a second optical length for the second laser beam; locking the first laser beam and the second laser beam to the optical resonator; obtaining a resulting signal by interference of the first laser beam and the second laser beam; determining, by a beat detector arrangement, a beat frequency of the resulting signal, wherein the beat frequency corresponds to the radio frequency signal.

The method and the optical resonator arrangement make use of a polarization dependent resonant frequency in an optical cavity. For differently polarized optical beams, the length of an optical path is different due to the birefringent material of the mirrors (e.g., applied as a coating of the mirrors). These different path lengths are used as a source for optically generated ultra-low noise (in phase and frequency) radio frequency signals. The stability and noise spectrum of the radio frequency signal is similar or same as in the optical domain. The method and the optical resonator arrangement allow a direct link from the optical frequency range to the radio frequency range without requiring additional components like a frequency comb. The method and the optical resonator arrangement may provide a short terms stability of the radio frequency signal up to 100 seconds, for example. The mirrors with the birefringent material provide two slightly different optical lengths for the optical cavity. This means that the cavity has two slightly different resonant optical frequencies for two different polarizations (here linear). These can be either excited by two lasers with two orthogonal polarizations or by frequency modulation (side band) of a single laser beam. By using a polarizer at 45°, the two lasers will create a beat frequency (RF frequency) at the frequency difference of the two lasers.

The optical resonator referred to in the description of the method may be the optical resonator described with one of the embodiments of the optical resonator arrangement.

Brief description of the drawings

The subject matter will hereinafter be described in conjunction with the following drawing figures, wherein like numerals denote like elements, and wherein:

Fig. 1     is a schematic representation of an optical cavity with an impinging laser and photodiode and camera;
Fig. 2     is a schematic representation of an optical resonator;
Fig. 3     is a schematic representation of different optical lengths between mirrors of an optical resonator;
Fig. 4     schematically shows an arrangement for locking a laser to an optical resonator;
Fig. 5     schematically shows an arrangement for stabilizing an electro-optical modulator by residual amplitude modulation;
Fig. 6     schematically shows an arrangement for power stabilization using an acousto-optical modulator;
Fig. 7     schematically shows an optical cavity with birefringent mirrors;
Fig. 8     schematically shows an optical resonator arrangement for generating RF signals;
Fig. 9     schematically shows an optical resonator arrangement for determining the frequency of an optical signal of a test device;
Fig. 10    schematically shows the structure of a birefringent mirror with multiple birefringent material layers.

Detailed description of the drawings

The following detailed description is merely exemplary in nature and is not intended to limit the invention and uses of the invention. Furthermore, there is no intention to be bound by any theory presented in the preceding background or the following detailed description.

The representations and illustrations in the drawings are schematic and not to scale. Like numerals denote like elements.

A greater understanding of the described subject matter may be obtained through a review of the illustrations together with a review of the detailed description that follows.

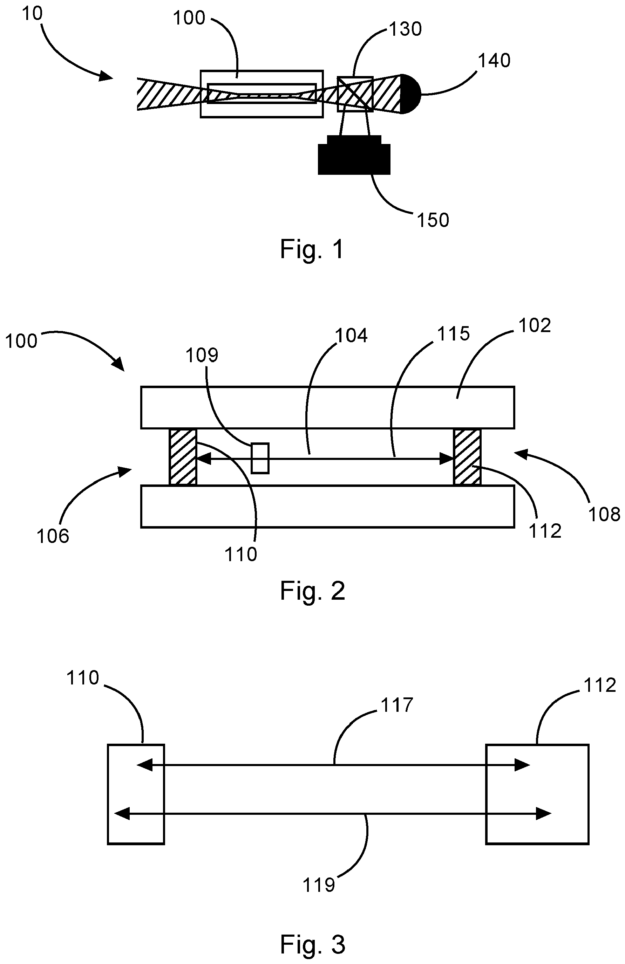

Fig. 1 shows an optical resonator arrangement 10 with an optical resonator 100, a beam splitter 130, a photodiode 140, and a detection camera 150.

In general, an optical cavity or an optical resonator is a closed path for a light beam. The simplest optical cavity consists of two parallel mirrors, where the laser beam bounces perpendicular to the mirror surfaces back and forth. As can be simply imagined, this cavity is not stable as the slightest movement of the mirrors will cause the beam walk off the mirrors after a few bounces. To prevent this, practical cavities are built with curved mirrors to keep the light path stable and closed.

For the sake of simplicity, only cavities with two mirrors separated by a plan parallel spacer of length I will be considered in the following. If the mirrors are chosen with a proper curvature, laser light can be trapped inside the cavity, provided it has a frequency that matches with a so called mode of the cavity: simply speaking, the path of the light beam is closed, and the length of the path is a multiple of the wavelength of the laser. That is, the laser is resonant with the cavity. Therefore, there are only certain modes. These modes can be described with two transversal parameters (path) and one longitudinal parameter (frequency). The simplest and usually most stable and desired mode is the transverse electromagnetic mode TEM 00. In this mode, the intensity profile of the laser in the cavity is a gaussian distribution and the laser beam is perpendicular to the mirror surfaces. In this case, the resonance condition is defined by eq. (1):

$$f_r = n\frac{c}{2l} \qquad (1)$$

where n is a (large) natural number, c is the speed of light, and l is the length of the spacer. The spacing between the frequencies of the resonance condition is the free spectral range (FSR):

$$FSR = \frac{c}{2l} \qquad (2)$$

The typical size of such an optical cavity is about 10 cm length (ranging from a few millimeters to 50 cm) and the diameter of the mirror is 1 cm, the diameter of the laser w (waist) is a few hundred micrometers. The modes can be observed by a camera 150 behind the outlet mirror (on the right of the resonator) opposite to the inlet mirror (on the left of the resonator) the laser is entering the cavity and scanning the laser frequency as shown in Fig 1.

Another parameter of an optical resonator is the finesse of a cavity. It describes the relation of the frequency spacing (free spectral range FSR) to the width of the resonance $\delta v$ which is limited due to mirror imperfections:

$$F = \frac{FSR}{\delta v} \qquad (3)$$

For cavities with large finesse (> 100) the losses per round trip (1-p) is directly related to the finesse with

$$F = \frac{2\pi}{1-\rho} \qquad (4)$$

A typical finesse for spectroscopical applications is greater than 100000 and above, corresponding to losses in the order of 1e-5 per round trip. Due to the small round trip loss, the finesse is usually measured in so called cavity ring down measurements. For example, when the laser is suddenly switched off (within 10 of nano seconds), one can observe that the output mirror is exponentially decaying. The decay time is an important factor in the short term stability of the cavity and power spectral density.

Fig. 2 is a schematic representation of an optical resonator 100. The optical resonator 100 comprises a housing 102 that at least partially surrounds a cavity 104 (hollow space). The housing 102 has an inlet opening 106 and an outlet opening 108. A first mirror 110 is arranged close to the inlet opening 106, and a second mirror 112 is arranged close to the outlet opening 108. The first mirror 110 and the second mirror 112 are spaced apart at a physical distance 115. The physical distance 115 is the distance between the surfaces of the first mirror 110 and the second mirror 112 that are faced towards each other. A birefringent element 109 is located between the first mirror 110 and the second mirror 112 so that the laser beams pass through the birefringent element when they are reflected by the mirrors 110, 112. The optical paths of differently polarized laser beams through the birefringent element 109 are different. Therefore, the optical lengths of the cavity for differently polarized laser beams is different although the physical distance between the mirrors 110, 112 is the same. In the example of Fig. 2, the birefringent element 109 is located between the mirrors. It should be understood that the mirrors 110, 112 may have birefringent characteristics alternatively (or in addition) to using a separate birefringent element 109 in between.

Fig. 3 schematically shows different optical lengths of an optical resonator. When the first mirror 110 and the second mirror 112 comprise birefringent material, differently polarized optical beams are reflected at a different depth with reference to the outer surface. Depending on the polarization of the impinging optical beams, e.g., laser beams, the optical lengths for horizontally and vertically polarized laser beams are different. For example, a first optical length for vertically polarized laser beams is different to a second optical length for horizontally polarized laser beams. In the example of Fig. 3, the optical length 117 is shorter than the optical length 119.

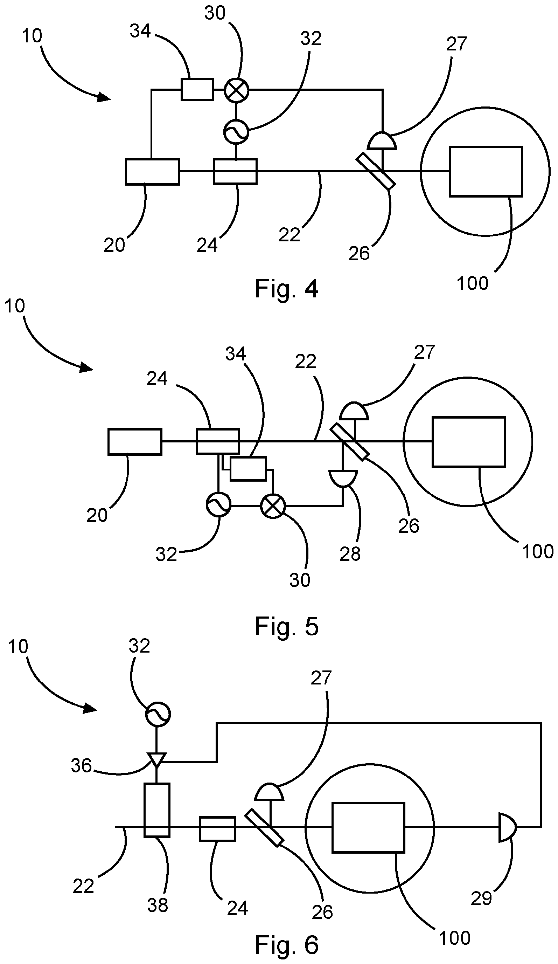

Now, with reference to Fig. 4, it is described how a laser is locket to an optical resonator.

Fig. 4 schematically shows an optical resonator arrangement 10 with a laser 20 that emits a laser beam 22 towards an optical resonator 100. The laser beam 22 passes an electrooptical modulator 24 and a beam splitter 26 on its way to the optical resonator 100. The electrooptical modulator 24 is configured to vary a frequency of the laser beam. The beam splitter 26 divides the laser beam 22 so that a portion of the laser beam is passed to the optical resonator 100 and another portion is reflected towards a photodiode 27 which transmits a signal to the mixer 30. The mixer 30 is connected to an RF local oscillator 32 and a low pass filter 34.

To keep a laser resonant to a cavity, a feedback signal is used. This feedback signal may either come from a reduced reflection from the cavity or an enhanced transmission. Both signals as such are not useful for high end applications, as the laser may fluctuate and drift in power. From signal theory it is clear that an error signal should be a linear zero crossing which is not possible with the raw signal. A frequency side band with frequency $\Omega$ is ideally only phase modulated on the laser using an electro optical modulator. The electric field of the laser is then

$$E = A \sin\left(\omega t + \beta \sin(\Omega t)\right) \qquad (5)$$

wherein $\beta$ is the modulation depth Therefore the laser has now three frequencies (f - $\Delta$f, f, f + $\Delta$f) as can be shown by expanding the electric field term using Bessel functions. The central frequency is called carrier and the other two frequencies are side bands. The modulation frequency is typically a few MHz and does not have to be very stable. The laser is now tuned such that the carrier is partially transmitted into the cavity. Some power of the carrier is leaking out of the mirror where the laser is impinging. Then the reflected carrier is phase shifted to the reflected side bands which leads to a beat node when detected on a photodiode 27 as shown in Fig. 3. This beat node can now be mixed with the same frequency as the modulation using standard RF techniques. The output is near DC and twice the modulation frequency. By applying a low pass, only the DC part remains. The phase relation of the RF signal to mix down the RF signal from the photodiode can be set such that the signal is zero when the carrier is on resonance. When the laser is slightly drifting off the resonance, part of the carrier is reflected as well shifting the phase relation between the reflected carrier and one of its side bands. This can then be seen on the mixed down signal as a finite voltage. The voltage is then transformed into a suitable range to tune the laser back to resonance. The error signal is large and steep especially for cavities with a high finesse. Therefore, the laser can be made orders of magnitude narrower than the resonant width $\delta v$ of the laser. At this point it is noted that it is also possible to tune the laser away from the cavity mode. This is done by modulating a large frequency (relative to the side bands for locking) onto the laser. This side band is then modulated again to create the locking side bands. Now the frequency offset of the laser can be tuned to tune the laser relative to the cavity resonance.

Fig. 5 shows an optical resonator arrangement 10 with measures for stabilizing a laser onto the optical resonator 100. Same reference signs are used in Fig. 5 for components that are similar or identical in function to those in Fig. 4. The beam splitter 26 reflects part of the laser beam 22 to a first photodiode 27 and a second photodiode 28 which is used for residual amplitude modulation, RAM.

Generally, the stability of the laser is limited by the stability of the mounting of the cavity and the cavity itself and residual noise contributions due to the lock technique. The frequency noise of the laser is directly related to the length noise of the cavity as shown in eq. (6) (length noise meaning noise caused by slight variation in length of the cavity, due to any external influence, e.g., mechanical or thermal influence)

$$\frac{\delta f}{f} = -\frac{\delta l}{l} \qquad (6)$$

The notion of a laser line width becomes meaningless as the different noise sources have different noise characteristics that may be far from the common white noise that leads to a gaussian distribution in frequencies. For example, the cavity may drift due a settling and thermal expansion of the spacer, show thermal noise from the mirrors and so on. To understand and distinguish between different noise sources, the power spectral density, and the Allan deviation are introduced. Both measures stem from the correlations of the signal (here the frequency of the laser) as a function of the time difference between two measurements. The power spectral density is the Fourier transformation of the autocorrelation function. It answers the question how much noise/instability is contained in the signal given a small frequency range? The Allan deviation is related to the power spectral density, PSD, by integration of the PSD with a frequency dependent factor. It answers the question of how long one has to wait to obtain a certain (best) precision in the signal. This time is often finite as the instruments and therefore its signal drifts or starts to fluctuate (flicker noise as in contrast to white noise).

High end cavities have typically a minimum instability of a several seconds before they start to drift or hit the flicker floor (Allan deviation). In the ideal case, both are physical and not technical limits. Typical noise sources and their mitigation strategies are shown in the following table:

| effect | time scale | noise type | mitigation strategy |
|---|---|---|---|
| mechanical vibration | ms to s | | mechanical isolation and design |
| thermal expansion spacer | s | drift | crystalline spacer, ultra-low expansion and coefficient of thermal expansion point, thermal isolation |
| thermal noise substrate | $\mu$s | flicker | high Q substrate or cooling |
| tension substrate | s | drift | compensation rings |
| thermal noise coating | $\mu$s | flicker | crystalline mirror, cryocooling |
| intra cavity fluctuation of refractive index | ms | flicker | ultra-high vacuum |
| intra cavity intensity fluctuation | ms | flicker | transmission measurement and power stabilization |
| residual amplitude modulation (RAM in EOM | ms to s | flicker | RAM stabilization on EOM with DC voltage |
| light path stabilization | ms to s | flicker | fiber stabilization with AOM |

For the active stabilization, two contributions are particularly mentioned: The residual amplitude modulation and the optical power stabilization.

The former is a residual amplitude modulation due to the EOM to create side bands. This is shown in Fig. 5 and can be measured by picking some of the light beam 22 impinging onto the cavity 100 and measure the amplitude modulation by the photodiode 28 and feed it back to the EOM 24 (via the mixer 30, the RF local oscillator 32, and the low pass filter 34) which applies a DC voltage on the crystal on top of the field for side band modulation.

Power fluctuations in the cavity 100 can cause a fluctuation in radiation pressure on the mirrors or change the temperature of the mirror coatings and change the optical length of the cavity. Therefore, the cycling power of the cavity is measured with a third photo diode 29 at the output mirror of the cavity 100 as shown in Fig 6 and is fed back to some power regulating optoelectronics (acousto-optical modulator 38 via a variable amplifier 36 for RF signals) or to the laser directly.

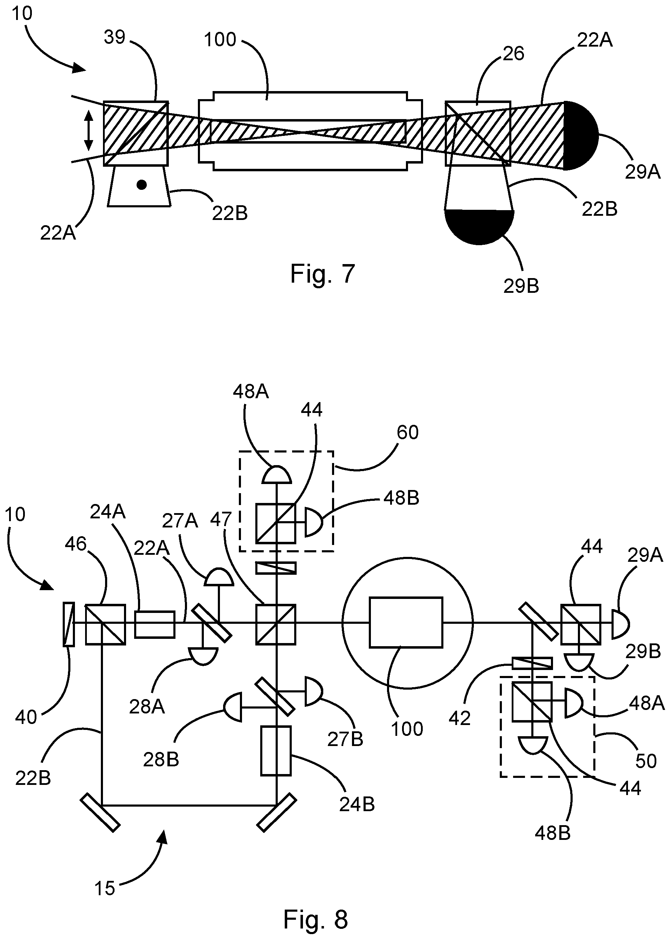

Fig. 7 schematically shows an optical resonator arrangement 10 with an optical resonator 100. A first mirror is arranged at the inlet opening (left opening) and a second mirror is arranged at the outlet opening (right opening), as shown in Fig. 2. The first mirror and the second mirror are birefringent mirrors.

A first laser beam 22A with a first polarization (e.g., vertical polarization) and a second laser beam 22B with a second polarization (e.g., horizontal polarization, orthogonal to the first polarization) are emitted towards a feeder arrangement 39 that directs both laser beams 22A, 22B towards the cavity of the optical resonator 100. As shown in Fig. 3, the optical lengths of the optical resonator 100 for the first and second beam 22A, 22B are different. Therefore, the frequency of the first and second beam 22A, 22B is also different when these two laser beams are locked to the optical resonator 100. The first and second laser beams 22A, 22B exit the outlet opening and a polarization dependent beam splitter 26 directs the second laser beam 22B to the photodiode 29B and lets the first laser beam 22A pass to the photodiode 29A.

Having described how to lock a laser (e.g., the first laser beam 22A) to an ultra-stable cavity to obtain ultra-stable optical frequencies, the focus is now and with reference to Fig. 7 and 8 on how to produce RF frequency signals.

One option is to lock a second laser (e.g., the second laser beam 22B) on the cavity 100 with a frequency difference of one FSR. To facilitate the process, the polarization of the laser is exploited. Light is an electromagnetic transversal wave. It therefore has two orthogonal linear polarizations: vertical and horizontal. Therefore, it is possible to overlap two laser beams with the same or different frequency and distinguish them from each other by polarization. This means it is possible to lock two lasers on an optical cavity with a frequency difference of the FSR. One FSR leads to the rather large frequency difference of several GHz that are strongly damped in cables and sensitive to stress of the cables that leads to unwanted phase noise. To generate low frequency RF signals (several tens or hundreds of MHz, for example 100 MHz or less) the cavity would need to be built with a length of the order of meters. This is not practical outside dedicated laboratories. When, however, the cavity contains a slightly birefringent element, the two longitudinal modes for the two polarizations are not the same anymore due to the different optical lengths of the optical resonator for different polarizations.

An optical element is birefringent if it is transparent and the optical length, which is the geometrical length multiplied with the refractive index, is polarization dependent:

$$ln_H \neq ln_V \qquad (7)$$

This phenomenon is known for calcite, for example, where two slightly shifted images can be seen if looking through it from an angle not parallel to the c-axis. The difference in refractive index can be small and if the thickness is small, the optical path difference can be a fraction of a wavelength. This small path difference means that the two laser modes will beat at a low RF frequency (low when compared to the frequency of the laser signals), provided they are at the same polarization. The latter can be easily established by using a polarizer turned at 45° to either of the polarizations.

The next equations show this. Without loss of generality, we chose the first laser beam to be vertically polarized. This laser is locked to the cavity with the frequency as shown in eq. (8)

$$f_v = n\frac{c}{2l_v} \qquad (8)$$

where $l_v$ is the optical length of the cavity for the vertical polarization and n is the mode number of the longitudinal modes. A second laser beam with horizontal polarization is locked to the cavity with a frequency as shown in eq. (9)

$$f_h = n\frac{c}{2l_h} \qquad (9)$$

The beat frequency between these lasers is then

$$\Delta f = n\frac{c(l_h-l_v)}{2l_hl_v} \qquad (10)$$

$$\approx n\frac{c(l_h-l_v)}{2l^2} \qquad (11)$$

To obtain a frequency of 100 MHz given a length of 5 cm of the cavity and a wavelength of 1064 nm (to obtain a longitudinal mode number) gives a path difference of 18 nm. Note that by choosing the longitudinal mode the RF frequency can be tuned in fine steps of kHz.

Using the principle of the optical resonator arrangement describes herein has the advantage, that the high finesse for low noise in the optical domain is directly transferred into the RF domain. Preferably, the mirrors of the optical resonator are crystalline and birefringent. Thus, the reflection does not occur at the surface. The coating may consist of several layers and the birefringence can be directly observed on the shift of the beat frequency when the polarization of a laser beam is turned 90°.

Fig. 8 shows an optical resonator arrangement 10 for generating RF signals. A laser beam is emitted to pass a lambda/2 waveplate 40. This lambda/2 waveplate 40 may be a 45° polarizer and emits differently polarized laser beams towards the polarizing beam splitter 46. The polarizing beam splitter 46 splits the laser beam in dependence of the polarization. Laser light with a first polarization is passed to the first electrooptical modulator 24A and laser light with a second polarization is reflected towards the second electrooptical modulator 24B. This may be referred to as two different lights paths. The first electrooptical modulator 24A is located in the first light path and the second electrooptical modulator 24B is located in the second light path. The second light path may include mirrors to reflect and direct the laser in this light path towards the second electrooptical modulator 24B.

The first and second electrooptical modulators 24A, 24B are configured to vary the frequency of the laser light passing along the respective light path. For this purpose, additional beam splitters and photodiodes 27A, 27B, 28A, 28B are arranged in the respective light path and implement the functions as described with reference to Figs. 4 to 6.

The laser beams of the first and second light path are differently polarized and have different frequencies. The laser beams are directed to the polarizing beam splitter 47. The polarizing beam splitter 47 directs part of the first and second laser beams into the optical resonator 100 and some part of the first and second laser beams into the second beat detector 60, which will be described in greater detail below.

By using the polarizing beam splitter 44 and the photodiodes 29A, 29B, the laser beams of the first light path and of the second light path are locked to the cavity, as described with reference to Figs. 4 to 7.

The laser beams leaving the optical resonator 100 at the outlet opening are split by a beam splitter and directed to the polarizing beam splitter 44 as well as to a lambda/2 waveplate 42 that is arranged upstream of the first beat detector 50.

The lambda/2 waveplate 42 is configured to change the polarization of the first laser beam and the second laser beam so that these are polarized in the same manner. The polarizing beam splitter 44 of the first beat detector 50 splits the received laser light and passes parts of the laser light to the first detector photodiode 48A and to the second photodiode 48B. At the first and second detector photodiodes 48A, 48B, the laser light of both light paths interferes so that the photodiodes 48A, 48B are able to detect the beat frequency resulting from the different frequency of the first laser beam and the second laser beam. The beat frequency is the frequency value for the RF signal. This frequency is a low frequency signal (compared to the frequency of the laser beams) and can be processed by standard RF technique.

The second beat detector 60 implements the same function as the first beat detector 50. The frequency of the first laser beam and the second laser beam is different upstream and downstream of the optical resonator once the laser beams are locked to the optical resonator. Generally, the beat frequency can be generated based on the laser beams at the polarizing beam splitter 47 (upstream of the optical resonator 100) or downstream of the optical resonator 100.

In one exemplary implementation, the laser is sent through a polarizing cube beam splitter. Half of the laser is sent directly to the optical resonator 100 with the setup shown before in Fig. 4 that creates an arbitrary offset side band at a chosen frequency $f_{EOM}$ and locking side bands on the offset side band. The polarization is chosen such that it is aligned with the fast or slow axis (short optical length) of the birefringent cavity. The reflected part (the part reflected at the polarizing beam splitter 46 towards the second electrooptical modulator 24B, the second light path) of the beam is sent through a similar setup. The difference here is that the EOM offset frequency of the second electrooptical modulator 24B is slightly different and locked to the optical resonator 100 and not the laser which is locked by the other output of the polarizing beam splitter. On the output side of the cavity, the two lasers can be distinguished by polarization, and both can be intensity stabilized. By choosing different side band frequencies, this may contribute to suppress cross talk between the two locks.

To obtain the RF signal either the output is used and a polarizer at 45° to let the two beams interfere and create RF frequency. This output has the advantage of the low pass filter of the optical cavity. Another possibility is the combination of the beams at a non-polarizing cube before the cavity. This has the advantage of high intensity to suppress electronic noise.

It is now important to understand the different noise sources in this case. From eq. 11 it can be seen that a change in length of the spacer quadratically contributes to the beat frequency, as expected from the transformation from high carrier frequency to low carrier frequency. Since the optical path's length is relevant, also the fluctuations of pressure are acting the same way as length fluctuations and may not cancel. For the power stabilization this means that both power stabilizations have to work as their noise is fully correlated through the pressure on the cavity mirrors and substrates. Therefore, noise contribution is simply doubled. Thermal noise on the mirror coatings may however drop out as both laser beams see the same coating. Other technical noise (RAM) is independent and is therefore added quadratically.

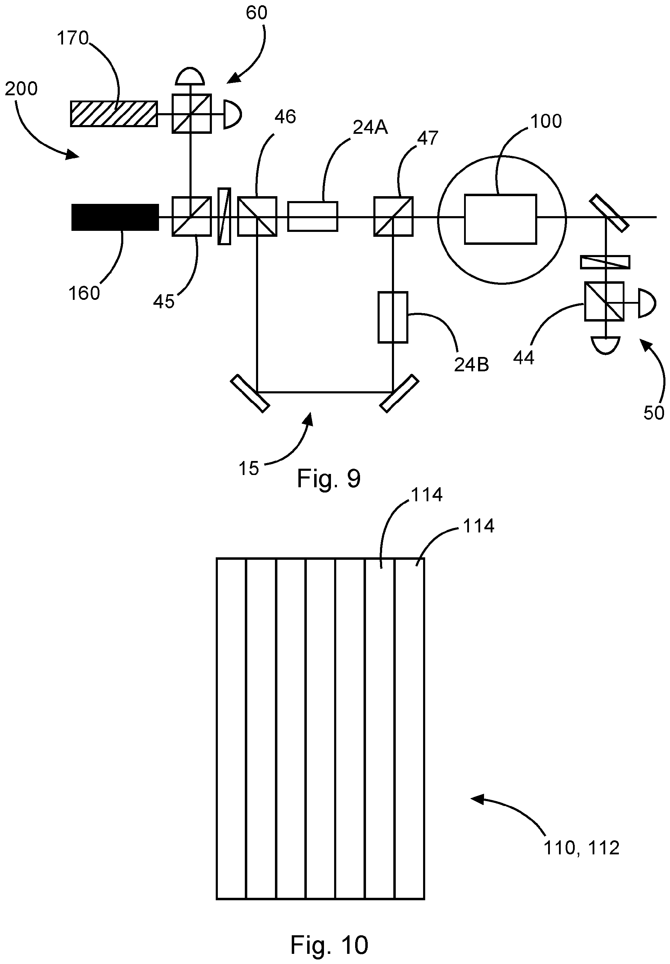

Fig. 9 shows an optical resonator arrangement in a use case of a wavemeter 200 for determining the frequency of an optical signal emitted by a test device 170.

The reference device 160 emits a laser beam similarly as described with reference to Figs. 4 to 8. This laser beam is polarized and split by polarizing beam splitter 46 so that it passes to different light paths through electrooptical modulators 24A, 24B (as described with reference to Fig 8). These two laser beams are locked to the optical resonator 100. The beat detector 50 is arranged to detect when the laser beams locked to the optical resonator 100 are locked to a mode of the optical resonator. The initial frequency of the laser beam emitted by the reference device 160 is known. The first beam (laser beam through the first optical path) and the second beam (laser beam through the second optical path) generate a beat frequency at the beat detector 50. The beat detector 50 is used to determine the mode n of the optical detector to which the laser beam of the reference laser is locked. When the frequency of the reference laser is varied, this variation can be determined by counting the number of modes n of the cavity that were passed by the variation of the frequency of the reference laser. However, the optical resonator arrangement with the two optical paths, the cavity with the two mirrors with birefringent material, and the beat detector is used to know the current frequency of the reference laser 160.

The laser beam of the reference laser 160 with its current frequency is not only directed towards the optical resonator 100, but it is also directed by the beam splitter 45 to the beat detector 60. The beat detector 60 receives the laser beam of the reference laser 160 and additionally the laser beam of the device under test 170.

The beat detector 60 detects the beat frequency between the laser beam of the reference laser 160 (with a known frequency) and the laser beam of the device under test 170 (with an unknown frequency). Once the beat frequency is detected at the beat detector 60, the unknown frequency of the laser beam of the device under test 170 can be determined based on the frequency of the laser beam of the reference device 160 and the detected beat frequency.

This additional functionality of the optical resonator arrangement is described with reference to an exemplary implementation.

For a certain resonant laser frequency, the output RF frequency can be determined by eq. 11. This is proportional to the mode number n. The cavity can now be calibrated against another laser with a certain obtained RF frequency ΔF and an offset frequency from the laser frequency resonant with the laser and the cavity mode. When these two frequencies are memorized, any laser can be compared to the cavity locked laser and it can be determined what the frequency (and therefore the wavelength) is, as shown in Fig. 9.

Without loss of generality, we assume that the device under test, $L_{DUT}$, has a frequency higher than the measured frequency of the cavity locked laser which is at cavity mode n with the associated $\Delta f_n$ and an offset -FSR < $f_{off}$ < FSR from a well-known laser standard. These two numbers represent the calibration.

$L_{DUT}$ is at an unknown mode number m plus an unknown offset $f_{off2}$, i.e., the frequency of the device under test. The task is to find m-n (the number of modes between the mode of the reference laser and the test laser in order to vary the frequency of the reference laser to a mode adjacent to the frequency of the device under test, i.e., either to the mode directly below or directly above the frequency of the device under test) and the $f_{off2}$. The cavity laser is scanned over the offset using the electrooptical modulator 24A. The scan range is preferably in the order of the FSR. At the same time, the beat frequency at the photo diodes of the beat detector 60 is observed. If the frequency difference between the frequency of the reference laser and the frequency of the device under test is small enough (i.e., less than the difference between one mode of the optical resonator 100), the photo diodes of the beat detector 60 will observe a beat note with a period longer than their response time. Is this not the case, the reference laser 160 will be locked to the next longitudinal mode n + 1 and the offset is scanned again. This step is repeated until n + (m - n) = m. The beat frequency at the beat detector 50 has now changed to

$$n + (m - n)\frac{c(l_h - l_v)}{2l^2} \qquad (12)$$

The beat frequency has therefore changed by

$$(n - m)\frac{c(l_h - l_v)}{2l^2} \qquad (13)$$

which can be easily measured as it is a few to several 100 kHz in discrete steps since m - n << n ≈ 1e5. This is done by standard RF techniques which require only a long term stability of 1e-7 which is trivial in the 10 MHz regime. However, the cavity has made frequency change of (m-n) FSR which are hundreds of GHz. The offset frequency is directly determined by the beat node of the photodiodes of the beat detector 60 $f_{RFW}$ and $f_{off}$. The frequency of $L_{DUT}$ is then

$$f_{DUT} = f_{ref} + (m - n)\frac{c(l_h - l_v)}{2l^2} + f_{RFW} - f_{off} \qquad (14)$$

The range of the wavemeter is only limited by the tuning range of the laser and the coating range of the mirrors of the cavity. It is immediately clear that by using well known laser frequency doublers (e.g., second harmonic generators, SHG) and dividers (e.g., down conversion), the range of the wavemeter can be set to the laser under test over a large range. Note that for using the laser as a wavemeter, the cavity finesse does not have to be that large and broad band coatings can be used for the mirrors of the cavity.

Fig. 10 schematically shows a mirror 110, 112 with multiple layers 114. These multiple layers include birefringent material and the differently polarized laser beams are reflected by such a multi-layered mirror at different layers (when impinging the mirror perpendicular to the layers, i.e., from left to right or vice versa in the depicted drawing) so that the optical length of an optical resonator with such mirrors depends on the polarization of the laser beams.

While at least one exemplary embodiment has been presented in the foregoing detailed description, it should be appreciated that a vast number of variations exist. It should also be appreciated that the exemplary embodiment or exemplary embodiments are only examples, and are not intended to limit the scope, applicability, or configuration of the invention in any way. Rather, the foregoing detailed description will provide those skilled in the art with a convenient road map for implementing an exemplary embodiment of the invention. It will be understood that various changes may be made in the function and arrangement of elements described in an exemplary embodiment without departing from the scope of the claims.

Additionally, it is noted that "comprising" or "including" does not exclude any other elements or steps and "a" or "an" does not exclude a multitude or plurality. It is further noted that features or steps which are described with reference to one of the above exemplary embodiments may also be used in combination with other features or steps of other exemplary embodiments described above. Reference signs in the claims are not to be construed as a limitation.

List of reference signs

| | |
|---|---|
| 10 | optical resonator arrangement |
| 15 | laser beam feeder |
| 20 | laser |
| 22 | laser beam |
| 24 | electrooptical modulator |
| 26 | beam splitter |
| 27 | first photodiode (Pound-Drever-Hall, PDH) |
| 28 | second photodiode (residual amplitude modulation, RAM) |
| 29 | third photodiode (transmission measurement, PDT) |
| 30 | mixer |
| 32 | RF local oscillator |
| 34 | low pass filter |
| 36 | variable amplifier for RF |
| 38 | acousto-optical modulator |
| 39 | feeder |
| 40 | lambda/2 waveplate |
| 42 | lambda/2 waveplate |
| 44 | polarizing beam splitter |
| 45 | beam splitter |
| 46 | polarizing beam splitter |
| 47 | polarizing beam splitter |
| 48A | detector photodiode |
| 48B | detector photodiode |
| 50 | beat detector, first RF signal generating arrangement |
| 60 | beat detector, second RF signal generating arrangement |
| 100 | optical resonator |
| 102 | housing |
| 104 | cavity |
| 106 | inlet opening |
| 108 | outlet opening |
| 109 | birefringent element |
| 110 | first mirror |
| 112 | second mirror |
| 114 | layer of birefringent material |
| 115 | physical distance between first and second mirror |
| 117 | first optical length |
| 119 | second optical length |
| 130 | beam splitter |
| 140 | photodiode |
| 150 | detection camera |
| 160 | reference device |
| 170 | device under test |
| 200 | wavemeter arrangement, device for determining the wavelength of an optical signal |

**Claims**

1. An optical resonator arrangement (10) for generating a radio frequency signal, the optical resonator arrangement (10) comprising:

   a laser beam feeder (15), configured to emit a first laser beam (22A) having a first polarization and a first frequency and a second laser beam (22B) having a second polarization different to the first polarization and a second frequency different to the first frequency;
   an optical resonator (100), arranged to receive the first laser beam (22A) and the second laser beam (22B);

a beat detector arrangement (50, 60), arranged to receive the first laser beam (22A) and the second laser beam (22B) and configured to determine a beat frequency between the first laser beam (22A) and the second laser beam (22B);

wherein the optical resonator arrangement (10) is configured to lock the first laser beam (22A) and the second laser beam (22B) to the optical resonator (100);

wherein the optical resonator (100) comprises a housing (102) with a cavity (104), a first mirror (110), a second mirror (112), and at least one birefringent element (109);

wherein the first mirror (110) and the second mirror (112) are arranged at a predetermined physical distance (115) from each other along a path of the first laser beam (22A) and the second laser beam (22B);

wherein the at least one birefringent element (109) is arranged in the cavity (104) and defines a first optical length (117) for the first laser beam (22A) and a second optical length (119) for the second laser beam (22B).

2. The optical resonator arrangement (10) of claim 1,

wherein the at least one birefringent element (109) is located between the first mirror (110) and the second mirror (112); and/or

wherein the at least one birefringent element (10) is a part of one or both of the first mirror (110) and the second mirror (112).

3. The optical resonator arrangement (10) of claim 1 or 2,
wherein the first polarization is orthogonal to the second polarization.

4. The optical resonator arrangement (10) of any one of the preceding claims,
wherein each of the first mirror (110) and the second mirror (112) includes multiple layers (114) of birefringent material.

5. The optical resonator arrangement (10) of any one of the preceding claims,

wherein the first mirror (110) is arranged at an inlet opening (106) of the optical resonator (100);
wherein the second mirror (112) is arranged at an outlet opening (108) of the optical resonator (100);
wherein the cavity (104) extends between the inlet opening (106) and the outlet opening (108).

6. The optical resonator arrangement (10) of any one of the preceding claims,
wherein the first mirror (110) and the second mirror (112) are fixedly attached to the housing (102) of the optical resonator (100).

7. The optical resonator arrangement (10) of any one of the preceding claims,
wherein the beat detector arrangement (50, 60) includes a first beat detector (50) that is arranged to receive the first laser beam (22A) and the second laser beam (22B) at the outlet opening (108) of the optical resonator (100).

8. The optical resonator arrangement (10) of claim 7,

comprising a lambda/2 waveplate (42) that is arranged in a laser path of the first laser beam (22A) and the second laser beam (22B) between the optical resonator (100) and the first beat detector (50);
wherein the lambda/2 waveplate (42) is configured to modify the polarization of the first laser beam (22A) and/or the second laser beam (22B) so that the first laser beam (22A) and the second laser beam (22B) have the same polarization and interfere with each other to create a resulting signal.

9. The optical resonator arrangement (10) of claim 8,

wherein the first beat detector (50) includes a polarizing beam splitter (44), a first detector photodiode (48A), and a second detector photodiode (48B);
wherein the polarizing beam splitter (44) is configured to stabilize an intensity and to distribute an energy of the first laser beam (22A) and the second laser beam (22B) to the first detector photodiode (48A) and the second detector photodiode (48B).

10. The optical resonator arrangement (10) of claim 9,
wherein the first detector photodiode (48A) and the second detector photodiode (48B) are configured to determine the beat frequency of the resulting signal.

11. The optical resonator arrangement (10) of any one of the preceding claims,
wherein the beat detector arrangement (50, 60) includes a second beat detector (60) that is arranged to receive the first laser beam (22A) and the second laser beam (22B) at the inlet opening (108) of the optical resonator (100).

12. The optical resonator arrangement (10) of any one of the preceding claims, comprising:

a reference device (160), configured to emit a reference optical signal with a reference frequency towards the laser beam feeder (15) with the reference optical signal being the basis for emitting the first laser beam (22A) and the second laser beam (22B);
a test device (170), configured to emit a test optical signal at an unknown test optical signal frequency;
wherein the beat detector arrangement (50, 60) includes a second beat detector (60), arranged to receive the reference optical signal and the test optical signal, and configured to determine a beat frequency of the reference optical signal interfering with the test optical signal;
wherein the optical resonator arrangement (10) is configured to determine the test optical signal frequency of the test optical signal based on the beat frequency at the second beat detector (60) and the reference frequency.

13. The optical resonator arrangement (10) of claim 12,
configured to vary the reference frequency and to lock the reference optical signal to the optical resonator (100) at different modes of the optical resonator.

14. The optical resonator arrangement (10) of 13,
configured to determine a mode of the optical resonator (100) belonging to the varied reference frequency and to determine a value of the varied reference frequency based on the determined mode of the optical resonator (100).

15. A method for generating a radio frequency signal using a first laser beam and a second laser beam, the method comprising the steps:

emitting a first laser beam (22A) having a first polarization and a first frequency and a second laser beam (22B) having a second polarization different to the first polarization and a second frequency different to the first frequency towards an optical resonator with a cavity (102), a first mirror (110), a second mirror (112), and at least one birefringent element (109), wherein the first mirror (110) and the second mirror (112) are arranged opposite to each other with at least a part of the cavity (102) in between, and wherein the at least one birefringent element (109) is arranged in the cavity (104) and defines a first optical length (117) for the first laser beam (22A) and a second optical length (119) for the second laser beam (22B);
locking the first laser beam (22A) and the second laser beam (22B) to the optical resonator (100);
obtaining a resulting signal by interference of the first laser beam (22A) and the second laser beam (22B);
determining, by a beat detector arrangement (50, 60), a beat frequency of the resulting signal, wherein the beat frequency corresponds to the radio frequency signal.

**Amended claims in accordance with Rule 137(2) EPC.**

1. An optical resonator arrangement (10) for generating a radio frequency signal, the optical resonator arrangement (10) comprising:

a laser beam feeder (15), configured to emit a first laser beam (22A) having a first polarization and a first frequency and a second laser beam (22B) having a second polarization different to the first polarization and a second frequency different to the first frequency;
an optical resonator (100), arranged to receive the first laser beam (22A) and the second laser beam (22B);
a beat detector arrangement (50, 60), arranged to receive the first laser beam (22A) and the second laser beam (22B) and configured to determine a beat frequency between the first laser beam (22A) and the second laser beam (22B), wherein the beat frequency corresponds to the radio frequency signal;
wherein the optical resonator arrangement (10) is configured to lock the first laser beam (22A) and the second laser beam (22B) to the optical resonator (100);
wherein the optical resonator (100) comprises a housing (102) with a cavity (104), a first mirror (110), a second mirror (112), and at least one birefringent element (109);
wherein the first mirror (110) and the second mirror (112) are arranged at a predetermined physical distance (115) from each other along a path of the first laser beam (22A) and the second laser beam (22B);

wherein the at least one birefringent element (109) is arranged in the cavity (104) and defines a first optical length (117) for the first laser beam (22A) and a second optical length (119) for the second laser beam (22B);

**characterized in that**

the at least one birefringent element (109) is a part of one or both of the first mirror (110) and the second mirror (112), the at least one birefringent element (109) being a coating with multiple layers of birefringent material; the first mirror (110) and/or the second mirror (112) includes multiple layers (114) of birefringent material such that differently polarized laser beams are reflected by the first mirror (110) and/or the second mirror (112) at different layers.

2. The optical resonator arrangement (10) of claim 1,
wherein the first polarization is orthogonal to the second polarization.

3. The optical resonator arrangement (10) of any one of the preceding claims,

wherein the first mirror (110) is arranged at an inlet opening (106) of the optical resonator (100);
wherein the second mirror (112) is arranged at an outlet opening (108) of the optical resonator (100);
wherein the cavity (104) extends between the inlet opening (106) and the outlet opening (108).

4. The optical resonator arrangement (10) of any one of the preceding claims,
wherein the first mirror (110) and the second mirror (112) are fixedly attached to the housing (102) of the optical resonator (100).

5. The optical resonator arrangement (10) of any one of the preceding claims,
wherein the beat detector arrangement (50, 60) includes a first beat detector (50) that is arranged to receive the first laser beam (22A) and the second laser beam (22B) at the outlet opening (108) of the optical resonator (100).

6. The optical resonator arrangement (10) of claim 5,

comprising a lambda/2 waveplate (42) that is arranged in a laser path of the first laser beam (22A) and the second laser beam (22B) between the optical resonator (100) and the first beat detector (50);
wherein the lambda/2 waveplate (42) is configured to modify the polarization of the first laser beam (22A) and/or the second laser beam (22B) so that the first laser beam (22A) and the second laser beam (22B) have the same polarization and interfere with each other to create a resulting signal.

7. The optical resonator arrangement (10) of claim 6,

wherein the first beat detector (50) includes a polarizing beam splitter (44), a first detector photodiode (48A), and a second detector photodiode (48B);
wherein the polarizing beam splitter (44) is configured to stabilize an intensity of the first laser beam (22A) and the second laser beam (22B), and to distribute an energy of the first laser beam (22A) and the second laser beam (22B) to the first detector photodiode (48A) and the second detector photodiode (48B).

8. The optical resonator arrangement (10) of claim 7,
wherein the first detector photodiode (48A) and the second detector photodiode (48B) are configured to determine the beat frequency of the resulting signal.

9. The optical resonator arrangement (10) of any one of the preceding claims,
wherein the beat detector arrangement (50, 60) includes a second beat detector (60) that is arranged to receive the first laser beam (22A) and the second laser beam (22B) at the inlet opening (108) of the optical resonator (100).

10. The optical resonator arrangement (10) of any one of the preceding claims, comprising:

a reference device (160), configured to emit a reference optical signal with a reference frequency towards the laser beam feeder (15) with the reference optical signal being the basis for emitting the first laser beam (22A) and the second laser beam (22B);
a test device (170), configured to emit a test optical signal at an unknown test optical signal frequency;
wherein the beat detector arrangement (50, 60) includes a second beat detector (60), arranged to receive the reference optical signal and the test optical signal, and configured to determine a beat frequency of the reference optical signal interfering with the test optical signal;
wherein the optical resonator arrangement (10) is configured to determine the test optical signal frequency of the test optical signal based on the beat frequency at the second beat detector (60) and the reference frequency.

11. The optical resonator arrangement (10) of claim 10,
configured to vary the reference frequency and to lock the reference optical signal to the optical resonator (100) at different modes of the optical resonator.

12. The optical resonator arrangement (10) of claim 11,
configured to determine a mode of the optical resonator (100) belonging to the varied reference frequency and to determine a value of the varied reference frequency based on the determined mode of the optical resonator (100).

13. A method for generating a radio frequency signal using a first laser beam and a second laser beam, the method comprising the steps:

emitting a first laser beam (22A) having a first polarization and a first frequency and a second laser beam (22B) having a second polarization different to the first polarization and a second frequency different to the first frequency towards an optical resonator with a cavity (102), a first mirror (110), a second mirror (112), and at least one birefringent element (109), wherein the first mirror (110) and the second mirror (112) are arranged opposite to each other with at least a part of the cavity (102) in between, and wherein the at least one birefringent element (109) is arranged in the cavity (104) and defines a first optical length (117) for the first laser beam (22A) and a second optical length (119) for the second laser beam (22B), wherein the at least one birefringent element (109) is a part of one or both of the first mirror (110) and the second mirror (112), the at least one birefringent element being a coating with multiple layers of birefringent material, and wherein the first mirror (110) and/or the second mirror (112) includes multiple layers (114) of birefringent material such that differently polarized laser beams are reflected by the first mirror (110) and/or the second mirror (112) at different layers;
locking the first laser beam (22A) and the second laser beam (22B) to the optical resonator (100);
obtaining a resulting signal by interference of the first laser beam (22A) and the second laser beam (22B);
determining, by a beat detector arrangement (50, 60), a beat frequency of the resulting signal, wherein the beat frequency corresponds to the radio frequency signal.

Fig. 1

Fig. 2

Fig. 3

Fig. 4

Fig. 5

Fig. 6

Fig. 7

Fig. 8

Fig. 9

Fig. 10

Europäisches
Patentamt

European
Patent Office

Office européen
des brevets

# EUROPEAN SEARCH REPORT

Application Number

EP 21 21 4320

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PRADL O ET AL: "Fiber-coupled and monolithic cryogenic optical resonators", PRECISION ELECTROMAGNETIC MEASUREMENTS DIGEST, 2000 CONFERENCE ON, IEEE, 14 May 2000 (2000-05-14), pages 192-193, XP032399971, DOI: 10.1109/CPEM.2000.850941 ISBN: 978-0-7803-5744-0 | 1-8,15 | INV. H03B17/00 G02F1/00 G01J3/45 G01J3/28 G01N21/39 |
| A | * page 193, column 1, paragraph 1 – paragraph 2; figure 3 * | 9,10, 12-14 | |
| X | ANDRE N LUITEN ET AL: "Ultrafast Resonant Polarization Interferometry: Towards the First Direct Detection of Vacuum Polarization", ARXIV.ORG, CORNELL UNIVERSITY LIBRARY, 201 OLIN LIBRARY CORNELL UNIVERSITY ITHACA, NY 14853, 16 February 2004 (2004-02-16), XP080144428, DOI: 10.1103/PHYSREVA.70.033801 | 1-11,15 | |
| A | * page 4, paragraph 2 – page 5, paragraph 1; figure 1 * | 12-14 | TECHNICAL FIELDS SEARCHED (IPC) H03B G02F |
| A | US 2010/225897 A1 (FERMANN MARTIN E [US] ET AL) 9 September 2010 (2010-09-09) * figure 9 * | 1-15 | G01J G01N |

The present search report has been drawn up for all claims

| Place of search | Date of completion of the search | Examiner |
|---|---|---|
| Munich | 31 May 2022 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 21 4320

This annex lists the patent family members relating to the patent documents cited in the above-mentioned European search report.
The members are as contained in the European Patent Office EDP file on
The European Patent Office is in no way liable for these particulars which are merely given for the purpose of information.

31-05-2022

| Patent document cited in search report | Publication date | Patent family member(s) | Publication date |
|---|---|---|---|
| US 2010225897 A1 | 09-09-2010 | CN 102349205 A | 08-02-2012 |
| | | CN 103606815 A | 26-02-2014 |
| | | DE 112010000981 T5 | 27-09-2012 |
| | | DE 112010006131 B3 | 15-10-2020 |
| | | JP 5663499 B2 | 04-02-2015 |
| | | JP 2012519879 A | 30-08-2012 |
| | | US 2010225897 A1 | 09-09-2010 |
| | | US 2012081694 A1 | 05-04-2012 |
| | | US 2012145902 A1 | 14-06-2012 |
| | | US 2013148128 A1 | 13-06-2013 |
| | | US 2014219298 A1 | 07-08-2014 |
| | | US 2016094008 A1 | 31-03-2016 |
| | | WO 2010101690 A1 | 10-09-2010 |

EPO FORM P0459

For more details about this annex : see Official Journal of the European Patent Office, No. 12/82